Europäisches Patentamt

(19) **European Patent Office**

Office européen des brevets

(11) Publication number: **0 046 059**
**B1**

(12) **EUROPEAN PATENT SPECIFICATION**

(45) Date of publication of patent specification: **06.11.85**

(51) Int. Cl.⁴: **H 01 L 21/316,** C 23 C 14/10, C 23 C 14/22

(21) Application number: **81303589.6**

(22) Date of filing: **05.08.81**

(54) **Method of plasma enhanced chemical vapour deposition of films.**

(30) Priority: **08.08.80 JP 108164/80**

(43) Date of publication of application:
**17.02.82 Bulletin 82/07**

(45) Publication of the grant of the patent:
**06.11.85 Bulletin 85/45**

(84) Designated Contracting States:
**DE FR GB NL**

(56) References cited:
**EXTENDED ABSTRACTS, vol. 80, no. 1, May 1980, Princeton, T. YOSHIMI et al. "Plasma-activated deposition and some properties of phosphosilicate glass film", pages 236 to 238
JOURNAL OF THE ELECTROCHEMICAL SOCIETY, vol. 126, no. 6, June 1979, Manchester, J.R. HOLLAHAN "Deposition of plasma silicon oxide thin films in a production planar reactor", pages 930 to 934
EXTENDED ABSTRACTS, vol. 79, no. 1, May 1979, Princeton, M. VANDENBERG "Properties of plasma deposited silicon oxide", pages 262 to 264**

(73) Proprietor: **FUJITSU LIMITED**
**1015, Kamikodanaka Nakahara-ku Kawasaki-shi Kanagawa 211 (JP)**

(72) Inventor: **Shioya, Yoshimi**
**16-6-402, Namiki 1-chome Kanazawa-ku Yokohama-shi Kanagawa 236 (JP)**
Inventor: **Maeda, Mamoru**
**2-5-6-403, Toyogaoka Tama-shi Tokyo 192-02 (JP)**
Inventor: **Takasaki, Kanetake**
**26-10-703, Omorikita 1-chome Ota-ku Tokyo 143 (JP)**
Inventor: **Takagi, Mikio**
**6-20-3, Nagao Tama-ku Kawasaki-shi Kanagawa 213 (JP)**

(74) Representative: **Lawrence, Peter Robin Broughton et al**
**GILL JENNINGS & EVERY 53-64 Chancery Lane London WC2A 1HN (GB)**

Courier Press, Leamington Spa, England.

## Description

This invention relates to plasma enhanced chemical vapour deposition of certain silicate glass films (especially phosphosilicate glass films) on substrates such as silicon.

As is known, phosphosilicate glass films may be used as protective coatings or cover films or as interlaminar insulation films of wire pattern layers.

Such films may be made by the so-called atmospheric pressure method or by the so-called low pressure method. In the atmospheric pressure method, a phosphosilicate glass film is deposited on a substrate from a reaction gas mixture including $SiH_4$, $PH_3$ and $O_2$ under atmospheric pressure e.g. $1 \times 10^5$ Pa (760 Torr) and at a temperature of 350 to 450°C. In the low pressure method, a phosphosilicate glass film is deposited on a substrate from a reaction gas mixture including $SiH_4$, $PH_3$ and $O_2$ under a low pressure e.g. 131 Pa (1 Torr) and at a temperature of 350 to 450°C. Unfortunately phosphosilicate glass films obtained by these chemical vapor deposition methods suffer from some disadvantages. When the films are heat treated even at temperatures of about 600°C there is a tendency for cracks to be generated in the films. When the films are cooled to room temperature after the deposition the films are strained with the result that there is a tendency for cracks to be generated in the deposited films.

It would be desirable to be able to form phosphosilicate (or other silicate) glass films in such a way as to reduce or eliminate the tendency for the film to crack during high temperature heat treatment or to crack due to the stress caused by cooling to room temperature.

It is known to deposit nitride films or amorphous silicon by the so-called plasma enhanced (or assisted) chemical vapour deposition method. In this method a silicon nitride film or amorphous silicon film may be deposited at a relatively low temperature (e.g., 20—450°C) by applying radiofrequency between parallel flat plate electrodes to generate plasma gas. This method is described in, for instance, Journal of Electrochemical Society *125*, 601 (1978) and Electrochemical Society Meeting "Extended Abstract" 79—1, 262 (1979). This latter reference mentions processes using, as reaction gases, blends of $SiH_4$ with (a) $PH_3$ and $O_2$, (b) $N_2O$ or $O_2$ and (c) $PH_3$ and $N_2O$ or $O_2$, and also shows the effect of varying the ratio $PH_3:PH_3+SiH_4$.

According to the invention a phospho-, arseno- or boro-silicate glass film is deposited on a substrate by plasma enhanced chemical vapour deposition from a reaction gas mixture containing $SiH_4$, $N_2O$ and a hydride X where X is selected from $PH_3$, $AsH_3$ or $B_2H_6$, the mole ratio $N_2O:SiH_4$ is 50 or more and the mole ratio $X:SiH_4$ is 0.08 or less. The invention is particularly advantageously and effectively applied to the production of phosphosilicate glass in which event the gas mixture contains, as the hydride X, the gas $PH_3$ and is normally free of the other hydrides.

The following description is particularly related to the preferred process of the invention, namely the production of a phosphosilicate glass film, but may easily be adapted to the production of the other described silicate glass films.

In order to minimise the tendency for cracking due to high temperatures or due to the stress caused by cooling the film to ambient temperatures the mole ratio $N_2O:SiH_4$ must be 50 or more and preferably 50 to 100 and the mole ratio $PH_3$ (or $AsH_3$ or $B_2H_6$):$SiH_4$ should be 0.08 or less, preferably 0.03 to 0.06. If the mole ratio $N_2O:SiH_4$ is less than 50 then heat treatment of the phosphosilicate glass film may result in undesirable generation of cracks while if the mole ratio $PH_3:SiH_4$ is above 0.08 again heat treatment at high temperatures may result in undesirable generation of cracks.

The reaction gas mixture preferably consists substantially only of $SiH_4$, $N_2O$, $PH_3$ (or $AsH_3$ or $B_2H_6$), and inert gas, preferably argon.

The plasma enhanced chemical vapour deposition process is preferably conducted at a pressure of 13.1 to 262 Pa (0.1 to 2 Torr). It is preferably conducted at a temperature of 20 to 450°C. Preferably it is conducted using a radio frequency power of 50 KHz to 2.45 GHz. Apparatus and process conditions for it are known and are described in, for instance, the literature references identified above. The radio frequency may be applied between parallel flat plate electrodes to generate plasma gas. Alternatively the gas can be generated by applying the radio frequency to a radio frequency coil. Such a coil may for example be helically mounted on the outer surface of a deposition reaction tube that may be made of quartz, i.e. a so-called inductive coupling or coil coupling method.

The substrate on which the film may be deposited may be of, for instance, silicon, germanium, compound semiconductors (e.g. GaAs) or there may be an aluminium pattern on such a substrate. Thus there may be a cover film or passivation film or an interlaminar insulation film.

The invention will now be described with reference to the accompanying drawings in which:

Figure 1 is a schematic sectional view illustrating apparatus suitable for carrying out the plasma enhanced chemical vapour deposition method of the present invention;

Figure 2 is a graph illustrating a correlation between the stress of the silicon oxide and the mole ratio of $N_2O/SiH_4$ in the plasma chemical vapour deposition of Example 1;

Figure 3 is a graph illustrating a correlation between a reflection index (R.I.) of the plasma enhanced C.V.D. silicon oxide films (see curve A) or the density of the silicon oxide films (see curve B) and the mole ratio of $N_2O/SiH_4$ in the plasma chemical vapour deposition of Example 1 hereinbelow;

Figure 4 is a graph illustrating the correlation between an infrared absorption coefficient α of the silicon oxide film obtained in Example 1 hereinbelow;

Figure 5 is a graph illustrating the correlation between the stress of the phosphosilicate glass films deposited according to the plasma enhanced chemical vapour deposition method in Example 2 hereinbelow and the mole ratio of $N_2O/SiH_4$ wherein the correlation of the film according to the present invention is shown in curve A and the correlation of the film according to the conventional atmospheric pressure method is shown in curve B.

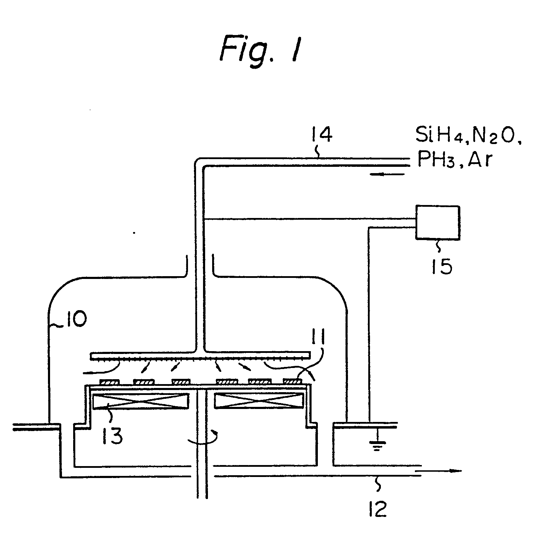

Referring to Figure 1, a plasma enhanced chemical vapour deposition method of a phosphosilicate glass film (i.e. PSG film) on a substrate 11 in a bell-jar type plasma enhanced chemical vapour deposition apparatus 10 will be now explained in detail. In the case where $B_2H_6$ gas or $AsH_3$ gas is used, in lieu of $PH_3$ gas, in the following procedure, a borosilicate glass film or an arsenosilicate glass film can be deposited on a substrate, respectively.

For instance, in the practice of the plasma enhanced chemical vapour deposition according to the present invention, a substrate 11 on which a PSG film should be deposited is placed in a bell-jar 10 made of, for example, quartz. The system within the bell-jar 10 is evacuated through a line 12 and the temperature of the atmosphere in the bell-jar 10 is heated to a temperature of 20 through 450°C, preferably 300 through 450°C by means of a heater 13, while the pressure of the system is maintained under a vacuum pressure of 13.1—262, preferably 66 to 131 Pa (0.1 to 2, preferably 0.5 to 1 Torr). Under the above-mentioned conditions, a reaction gas mixture of $SiH_4$, $N_2O$, $PH_3$ and Ar (for example, a gas mixture of 1% $SiH_4$ in Ar, 1% $PH_3$ in Ar and $N_2O$) is fed through a line 14 into the bell-jar 10. Then, a PSG film is deposited on the substrate 11 by applying a radio frequency power of 50 KHz through 2.45 GHz (most preferably 500 KHz) by using an oscillator 15.

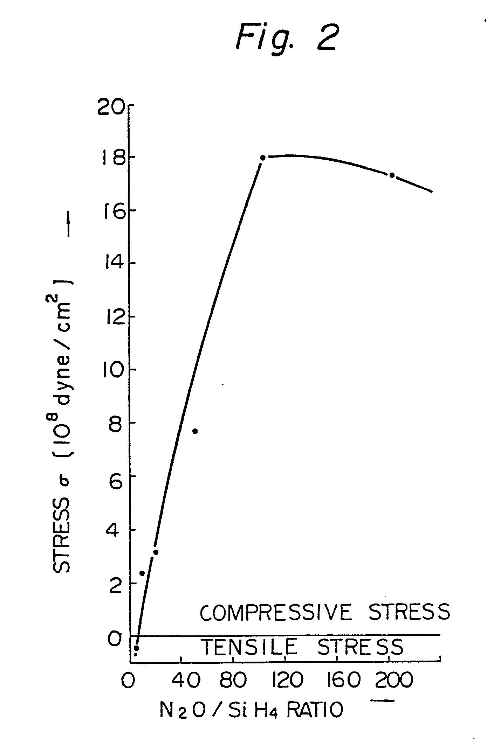

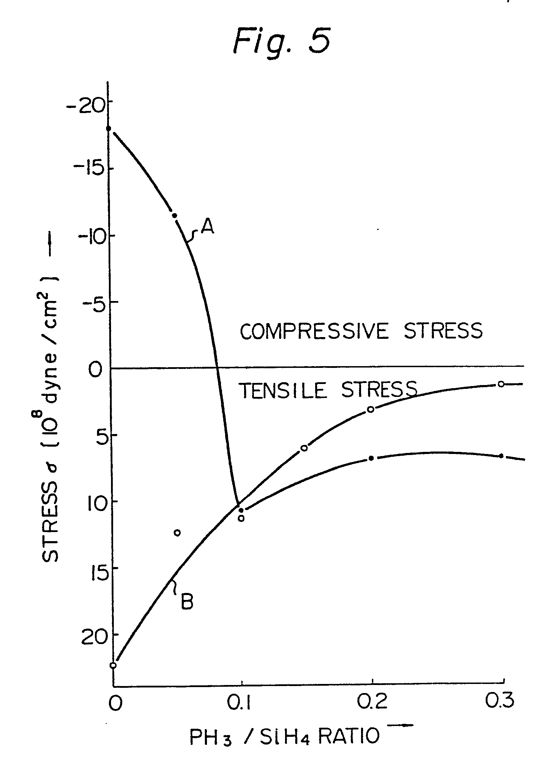

The invention is now illustrated in the following examples and by reference to the accompanying drawings. Example 1 and Figures 2 to 4 relate to a process that is not within the invention and in which a silicon oxide film is produced by carrying out the process in the absence of a hydride. This process is useful to an understanding of the invention since it shows the significance of the $N_2O:SiH_4$ ratio. Example 2 (and Figure 5) demonstrates the formation of a phosphosilicate glass by a process according to the invention and shows the significance of the $PH_3:SiH_4$ ratio.

Example 1

Silicon oxide films having a thickness of 1 micron were deposited on silicon substrates by using a plasma enhanced chemical vapour deposition apparatus as illustrated in Figure 1. The plasma deposition runs were carried out by using a reaction gas mixture of $SiH_4$, $N_2O$ and Ar under the following conditions.

Radio frequency: 13.56 MHz×40 W
Temperature: 300°C
Pressure: 131 Pa (1 Torr)
$N_2O/SiH_4$ Mole Ratio: 5, 10, 20, 50, 100 and 200.

The stress of each silicon oxide film deposited at the above-mentioned $N_2O/SiH_4$ ratios was determined. The correlation between the determined stress values σ (×$10^8$ dyne/cm or 103 N/cm) and the mole ratio of $N_2O/SiH_4$ is shown in Figure 2. The stress was determined according to a so-called Newton ring method.

Samples of the silicon oxide films having a thickness of 1 micron obtained from the above-mentioned plasma enhanced chemical vapour deposition at $N_2O/SiH_4$ ratios of 5, 50 and 100 were subjected to a heat-treatment at a temperature of 600°C, 800°C or 1000°C in a nitrogen atmosphere to observe the generation of cracking in the films. When the $N_2O:SiH_4$ ratio was 5 cracking was observed after heat treatment at each of the temperatures 600, 800 and 1000°C but with ratios of 50 and 100 no cracking was observed at any of these temperatures.

The reason why the use of a mole ratio $N_2O:SiH_4$ of 50 or more results in little or no cracking being generated at high temperature may be that the high ratio results in the content of $H_2$ in the deposited film being decreased and the density of the film being increased compared to the films obtained at lower mole ratios.

Furthermore, as shown in Figure 2, in the case where the mole ratios of $N_2O/SiH_4$ are 50 and 100, the deposited films are under compressive stress. Contrary to this, in the case where the mole ratio of $N_2O/SiH_4$ is 5, the deposited film is under tensile stress. The tensile stress in this film is further increased during the heat-treatment since the thermal expansion coefficient of the silicon substrate is larger than that of the deposited silicon oxide film. This, coupled with the fact that the content of $H_2$ in the deposited silicon oxide film is large and the deposited film is brittle, appears to be the cause of cracking being generated in the deposited films. Contrary to this, in the case where the mole ratio of $N_2O/SiH_4$ is 50 or 100, the compressive stress of the deposited film can be offset by the tension due to the difference in the thermal expansion coefficients between the silicon substrate and the deposited silicon oxide film. As a result, no cracking is generated in the deposited silicon oxide film.

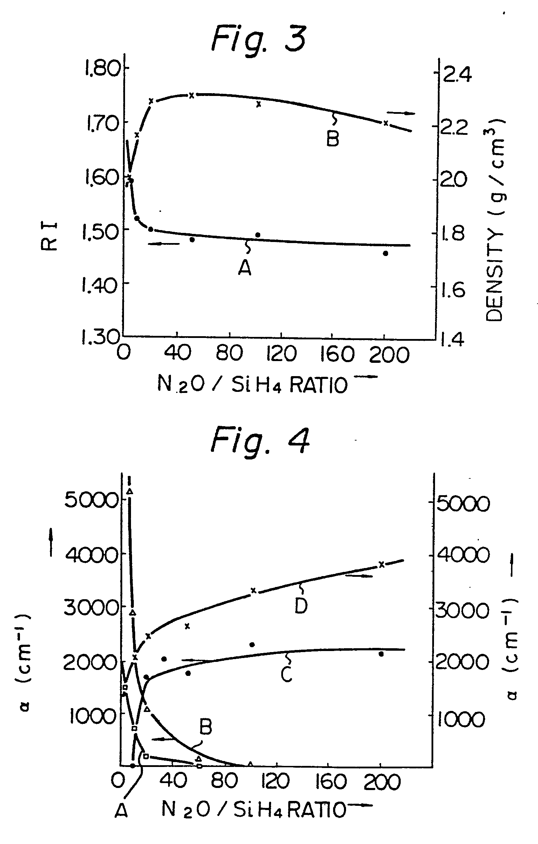

The correlation between the R.I. (i.e. refractive index) or the density of the silicon oxide film deposited on a silicon substrate and the mole ratio of $N_2O/SiH_4$ is illustrated in a graph of Figure 3. In Figure 3, curve A shows the correlation between the R.I. and $N_2O/SiH_4$ and curve B shows the correlation between the density and $N_2O/SiH_4$.

Furthermore, the correlation between an infrared absorption coefficient α of the silicon oxide film and the mole ratio of $N_2O/SiH_4$ is graphically

illustrated in Figure 4. In Figure 4, curve A shows the absorption coefficient (at 2240 cm⁻¹) of SiH, curve B the absorption coefficient (at 880 cm⁻¹) of $(SiH_2)_n$ or $Si_2O_3$, curve C the absorption coefficient (at 810 cm⁻¹) of SiO and curve D the absorption coefficient (at 1070—1090 cm⁻¹) of SiO (expansion and contraction).

As is clear from the graphs shown in Figures 3 and 4, the silicon oxide film obtained from the plasma enhanced chemical vapour deposition at the mole ratio of $N_2O/SiH_4$ of 50 or more, has a smaller content of $H_2$ as compared with the mole ratio of $N_2O/SiH_4$ of less than 50. Thus, $SiH_4$ is thoroughly reacted with $O_2$ at the mole ratio of $N_2O/SiH_4$ of 50 or more, whereby the silicon oxide film having good film properties can be formed.

Example 2

Phosphosilicate glass (PSG) films having a thickness of 1 micron were deposited on silicon substrates using a plasma enhanced chemical vapour deposition apparatus as illustrated in Figure 1. The plasma deposition runs were carried out by using a reaction gas mixture of $SiH_4$, $PH_3$, $N_2O$ and Ar under the following conditions.

Radio frequency: 13.56 MHz×40 W
Temperature: 300°C
Pressure: 131 Pa (1 Torr)
$N_2O/SiH_4$ Mole Ratio: 100
$PH_3/SiH_4$ Mole Ratio: 0*, 0.05, 0.1, 0.15, 0.2 and 0.3

The stress of each PSG film deposited at the various $PH_3/SiH_4$ ratios was determined in a manner as described in Example 1. The correlation between the stress values σ ($\times 10^8$ dyne/cm² or 103 N/cm²) and the mole ratio of $PH_3/SiH_4$ is shown in curve A of Figure 5.

As a comparison a phosphosilicate glass film having a thickness of 1 micron was deposited on a silicon substrate according to a conventional atmospheric pressure method. The deposition temperature was 425°C and the deposition pressure was 760 Torr. The composition of the reaction gas mixture was $SiH_4$, $PH_3$, $O_2$ and Ar. The stress of each PSG film deposited was determined in a manner as described above. The correlation between the stress σ and the mole ratio of $PH_3/SiH_4$ is shown in curve B of Figure 5.

Figure 5 shows that the film obtained by chemical vapour deposition is under tensile stress and that the stress increases with reducing phosphorus content. However the film obtained by the method of the invention is under compressive stress provided the phosphorus content is sufficiently low, and in particular provided the $PH_3:SiH_4$ ratio is below about 0.08, and that the compressive stress increases as the concentration of phosphorus is decreased. Accordingly the phosphosilicate glass films made by the invention have less tendency to crack than films made by

---

* In this case, silicon oxide film was deposited.

conventional chemical vapour deposition methods.

If the concentration of phosphorus in a phosphosilicate film is large the absorption of water from outside the film results in the formation of sufficient phosphoric acid in the film to cause significant decrease in the water vapour resistance of the film. Because the invention permits the production of satisfactory phosphosilicate glass films having a low phosphorus concentration it is possible by the invention to obtain such films having excellent water vapour resistance. The films of the invention are thus of particular value for purposes such as cover films and interlaminar insulation films.

## Claims

1. A method of depositing on a substrate a phospho-, arseno- or boro-silicate glass film by plasma enhanced chemical vapour deposition from a reaction gas mixture containing $SiH_4$, $N_2O$ and a hydride X, where X is selected from $PH_3$, $AsH_3$ or $B_2H_6$, the mole ratio $N_2O:SiH_4$ is 50 or more and the mole ratio $X:SiH_4$ is 0.08 or less.

2. A method according to claim 1 characterised in that the mole ratio $X:SiH_4$ is 0.03 to 0.06.

3. A method according to claim 1 or claim 2 characterised in that the mole ratio $N_2O:SiH_4$ is 50 to 100.

4. A method according to any preceding claim characterised in that the mixture consists substantially only of $SiH_4$, $N_2O$, X and inert gas.

5. A method according to any preceding claim characterised in that the plasma enhanced chemical vapour deposition is effected under a pressure of 13.1 to 262 Pa (0.1 to 2 Torr) at a temperature of 20 to 450°C.

6. A method according to any preceding claim characterised in that the plasma enhanced chemical vapour deposition is conducted using a radio frequency power of 50 KHz to 2.45 GHz.

7. A method according to any preceding claim characterised in that X is $PH_3$ and the film produced by the process is a phosphosilicate film.

## Patentansprüche

1. Verfahren zum Niederschlagen eines Phosphoro-, Arseno- oder Borosilikatglasfilms auf einem Substrat, durch ein plasmaverstärktes chemisches Dampfniederschlagungsverfahren, aus einer Reaktionsgasmischung, welche $SiH_4$, $N_2O$ und ein Hydrid X enthält, wobei X ausgewählt ist aus $PH_3$, $AsH_3$ oder $B_2H_6$, und das Molverhältnis $N_2O:SiH_4$ 50 oder mehr und das Molverhältnis $X:SiH_4$ 0,08 oder weniger beträgt.

2. Verfahren nach Anspruch 1, dadurch gekennzeichnet, daß das Molverhältnis $X:SiH_4$ 0,03 bis 0,06 ist.

3. Verfahren nach Anspruch 1 oder 2, dadurch gekennzeichnet, daß das Molverhältnis $N_2O:SiH_4$ 50 bis 100 ist.

4. Verfahren nach einem der vorhergehenden Ansprüche, dadurch gekennzeichnet, daß die Mischung im wesentlichen lediglich aus SiH$_4$, N$_2$O, X und einem inerten Gas besteht.

5. Verfahren nach einem der vorhergehenden Ansprüche, dadurch gekennzeichnet, daß das plasmaverstärkte chemische Dampfniederschlagungsverfahren unter einem Druck von 13,1 bis 262 Pa (0,1 bis 2 Torr) bei einer Temperatur von 20 bis 450°C durchgeführt wird.

6. Verfahren nach einem der vorhergehenden Ansprüche, dadurch gekennzeichnet, daß das plasmaverstärkte chemische Dampfniederschlagungsverfahren unter Verwendung einer Radiofrequenzleistung von 50 KHz bis 2,45 GHz durchgeführt wird.

7. Verfahren nach einem der vorhergehenden Ansprüche, dadurch gekennzeichnet, daß X PH$_3$ und der durch das Verfahren erzeugte Film ein Phosphorsilikatfilm ist.

**Revendications**

1. Procédé de dépôt sur un substrat d'une pellicule en verre de phosphosilicate, arséniosilicate ou borosilicate par dépôt chimique sous forme vapeur assisté par plasma à partir d'un mélange de gaz de réaction contenant SiH$_4$, N$_2$O et un hydrure X, où X est choisi parmi PH$_3$, AsH$_3$ et B$_2$H$_6$, le rapport molaire N$_2$O:SiH$_4$ valant 50 ou plus, et le rapport molaire X:SiH$_4$ valant 0,08 ou moins.

2. Procédé selon la revendication 1, caractérisé en ce que le rapport molaire X:SiH$_4$ est de 0,03 à 0,06.

3. Procédé selon la revendication 1 ou 2, caractérisé en ce que le rapport molaire N$_2$O:SiH$_4$ est de 50 à 100.

4. Procédé selon l'une quelconque des revendications précédentes, caractérisé en ce que le mélange n'est constitué sensiblement que de SiH$_4$, N$_2$O, X et un gaz inerte.

5. Procédé selon l'une quelconque des revendications précédentes, caractérisé en ce que le dépôt chimique sous forme vapeur assisté par plasma est réalisé sous une pression de 13,1 à 262 Pa (0,1 à 2 mm Hg) à une température de 20 à 450°C.

6. Procédé selon l'une quelconque des revendications précédentes, caractérisé en ce que le dépôt chimique sous forme vapeur assisté par plasma est effectué à l'aide d'une puissance de radiofréquence de 50 kHz à 2,45 GHz.

7. Procédé selon l'une quelconque des revendications précédentes, caractérisé en ce que X est PH$_3$ et en ce que la pellicule produite par le processus est une pellicule de phosphosilicate.

# Fig. 1

14    SiH$_4$,N$_2$O,
      PH$_3$,Ar

15

10

11

13

12

# Fig. 2

Fig. 3

Fig. 4

3

# Fig. 5